# FASCICULE DE BREVET EUROPEEN

(11) **EP 0 537 082 B1**
(45) Date de publication et mention de la délivrance du brevet: **04.03.1998**
(21) Numéro de dépôt: 92402777.4
(22) Date de dépôt: 09.10.1992
(51) Int. Cl.: G11C 16/06

(54) **Procédé pour vérifier le contenu après effacement d'une mémoire permanente effaçable, notamment de type EPROM, et mémoire permanente effaçable pour sa mise en oeuvre**
Inhaltsprüfungsverfahren für einen löschbaren ROM-Speicher, insbesondere des EPROM-Typs, und löschbarer ROM-Speicher zur Durchführung des Verfahrens
Method for verifying the contents of an erasable ROM, especially of an EPROM-type memory, and erasable ROM for carrying out the method

(30) Priorité: 11.10.1991 FR 9112538
(43) Date de publication de la demande: 14.04.1993
(73) Titulaire: SGS-THOMSON MICROELECTRONICS S.A., 94253 Gentilly Cédex (FR)
(72) Inventeur: Rouy, Olivier, F-13790 Rousset (FR)
(74) Mandataire: Schmit, Christian Norbert Marie

(56) Documents cités:
- EP-A- 0 409 672
- GB-A- 2 215 155
- 1990 IEEE INTERNATIONAL SOLID-STATE CIRCUITS CONFERENCE 14 Février 1990, pages 60 - 61 SEKI ET AL 'AN 80-NSEC 1MB FLASH MEMORY WITH ON-CHIP ERASE/ERASE-VERIFY CONTROLLER'
- 1990 SYMPOSIUM ON VLSI CIRCUITS 7 Juin 1990, HONOLULU pages 99 - 100 K.SHOHJI 'A NOVEL AUTOMATIC ERASE TECHNIQUE USING AN INTERNAL VOLTAGE GENERATOR FOR 1MBIT FLASH EEPROM'

## Description

La présente invention concerne un procédé pour vérifier le contenu après effacement d'une mémoire permanente effaçable, notamment de type EPROM.

Elle vise également une mémoire pour sa mise en oeuvre.

Une utilisation rationnelle des mémoires permanentes effaçables, notamment de type EPROM, implique une vérification systématique du contenu de ces mémoires après toute opération d'effacement.

Or, jusqu'à présent, la vérification du contenu d'une mémoire après effacement est effectuée par écriture d'une commande dans un registre de commande de la mémoire qui a pour effet de mémoriser la valeur d'une adresse et de lire le contenu à cette adresse après un temps de recouvrement nécessaire qui, à titre d'exemple, peut être de l'ordre de 6 µs. Un exemple est décrit dans GB-A-2.215.155.

Cette opération d'écriture d'une commande et de lecture doit être effectuée pour chaque adresse à vérifier, ce qui entraîne une perte de temps significative dans un contexte industriel. En outre, une telle vérification est effectuée plusieurs fois tant que la mémoire n'est pas reconnue comme complètement effacée, ce qui peut conduire à un temps total de véritication supérieur à une seconde.

Le but de l'invention est de remédier à ces inconvénients en proposant un procédé pour vérifier le contenu après effacement d'une mémoire permanente effaçable dotée d'un registre de commande et d'un registre d'adresse, le procédé comprenant une première étape d'écriture dans ce registre de commande d'un mot de commande de vérification d'effacement, suivie d'une seconde étape de temporisation de durée prédéterminée.

Suivant l'invention, la première étape d'écriture du mot de commande initie la séquence suivante:
- ouverture du registre d'adresse,
- présentation d'une première adresse,
- bouclage itératif de lecture du contenu à l'adresse visée et incrémentation de cette adresse jusqu'à ce que l'ensemble de la mémoire ait été vérifié, et
- fermeture du registre d'adresse.

Ainsi, avec le procédé selon l'invention, l'ensemble de la vérification ne comporte qu'une seule opération d'écriture et ne nécessite donc qu'une seule temporisation de recouvrement. Le registre d'adresse de la mémoire étant maintenu ouvert pendant toute la durée de la vérification, le bus interne d'adresse de la mémoire est alors en communication directe avec le bus du système numérique dans lequel la mémoire concernée est située et la lecture du plan mémoire peut être effectuée à une fréquence non limitée par le temps de recouvrement lié à la mise en oeuvre d'un cycle d'écriture.

Suivant une forme préférée de l'invention, la boucle comprend une étape de lecture de la donnée mémoire contenue à l'adresse en cours, suivie d'une étape de comparaison de ladite donnée avec une donnée de référence d'effacement, ladite étape de comparaison conduisant soit à une nouvelle itération en cas d'identité, soit à l'exécution d'une nouvelle séquence d'effacement en cas de différence.

Suivant un autre aspect de l'invention, une mémoire permanente effaçable, notamment de type EPROM, mettant en oeuvre le procédé décrit ci-dessus comprend un registre d'adresse, un registre de commande relié à un bus de données interne via un décodeur de statut, et un détecteur de fronts recevant en entrée un signal d'autorisation d'écriture et des moyens pour générer un signal d'autorisation de transfert d'adresse appliqué sur le registre d'adresse à partir d'un signal de véritication d'ettacement rapide généré par le détecteur de commande et d'un signal d'horloge d'adresse généré par le détecteur de fronts.

Le dispositif précité peut être intégré à des mémoires EPROM de structures diverses par ailleurs.

D'autres particularités de l'invention résulteront encore de la description ci-après.

Aux dessins annexés donnés à titre d'exemples non limitatifs :
- la figure 1 est un organigramme explicitant les étapes essentielles d'un algorithme d'effacement mettant en oeuvre le procédé selon l'invention;
- la figure 2 est un schéma fonctionnel simplifié d'une forme de réalisation du dispositif selon l'invention;
- la figure 3 est un chronogramme illustrant le déroulement séquentiel du procédé de vérification selon l'invention.

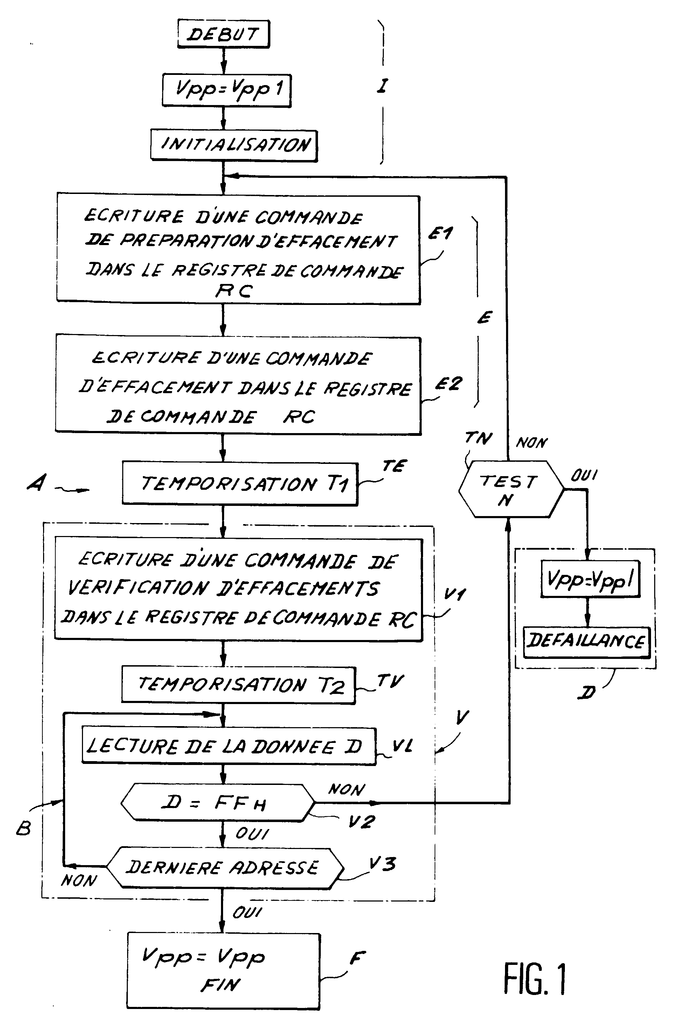

On va maintenant décrire de façon détaillée le procédé selon l'invention en même temps que le dispositif pour sa mise en oeuvre, en référence aux figures 1 à 3.

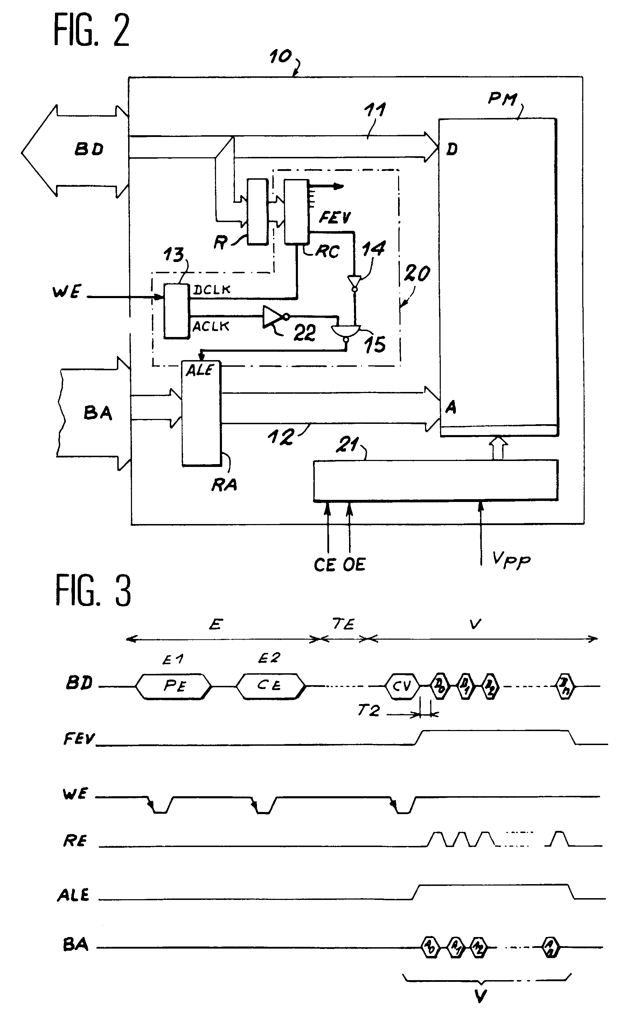

Le procédé de vérification selon l'invention est en pratique inclus au sein d'un algorithme d'effacement associé à une famille déterminée de mémoires effaçables et en particulier de mémoires de type EPROM, ce qui sera le cas dans la suite de la description. Cet algorithme A comprend d'une manière générale, en référence à la figure 1, une séquence d'initialisation I, une séquence de commande d'effacement E, une séquence de vérification d'effacement V qui constitue le procédé selon l'invention, suivies soit d'une séquence de fin F en cas d'exécution normale de l'algorithme, soit d'une séquence de détection de défaillance D. Cet algorithme est exécuté par un système numérique extérieur (non représenté) auquel est associée une mémoire EPROM 10 concernée par la procédure d'effacement, en référence à la figure 2.

Au cours de la séquence d'initialisation I, une tension de programmation Vpph de niveau haut est appliquée sur une entrée Vpp appropriée de la mémoire 10. La séquence de commande d'effacement comprend une étape E1 d'écriture d'une commande de préparation d'effacement dans un registre de commande RC de la mémoire 10. Cette étape provoque le positionnement de registres internes de la mémoire en mode d'effacement. Elle est suivie d'une étape d'écriture E2 d'une commande d'effacement dans le registre de commande RC à laquelle succède une étape TE de temporisation de durée prédéterminée T1, par exemple de l'ordre de 10 ms. Il est à noter que les séquences et étapes précitées correspondent à l'état présent de la technique dans le domaine des mémoires programmables.

A l'issue de la temporisation T1, le système numérique extérieur effectue une étape V1 d'écriture d'une commande de vérification d'effacement dans le registre de commande RC de la mémoire 10, immédiatement suivie d'une étape TV de temporisation de durée prédéterminée T2, par exemple de l'ordre de 6 µs, nécessaire pour garantir la stabilisation des circuiteries statiques de lecture en mode de vérification d'effacement de la mémoire. A l'issue de la temporisation T2, une boucle de lecture et de test B spécifique de l'invention est exécutée sur l'ensemble des adresses de la mémoire visée 10. Chaque itération de la boucle comprend une étape VL de lecture de la donnée D présente à l'adresse en cours, une étape V2 de comparaison de la donnée lue D à FF_{H} qui représente le contenu numérique normal attendu après effacement et qui constitue donc une valeur de référence d'effacement. Si la comparaison est satisfaisante, un test V3 d'adresse est effectué pour conduire, soit à une incrémentation de ladite adresse et à une itération de la boucle, soit, lorsque l'ensemble de la mémoire a été scruté, à la séquence F de fin de l'algorithme, au cours de laquelle un niveau bas Vppl est appliqué sur l'entrée de programmation Vpp.

Si au cours de l'étape V2 de comparaison, une donnée non égale à FF_{H} est détectée, une nouvelle séquence d'effacement E et une nouvelle séquence de vérification V sont entreprises de façon itérative jusqu'à ce que la vérification d'effacement soit satisfaisante. Un test TN sur le nombre N de séquences effectuées permet de limiter ces séquences à un nombre prédéterminé, par exemple égal à 3000. Au delà, la séquence D d'indication de défaillance de la mémoire 10 est effectuée, au cours de laquelle la tension de programmation Vpp est ramenée au niveau bas. Il faut noter que l'originalité de l'invention réside dans le fait que la boucle de lecture et de test n'inclut ni la séquence d'écriture de la commande de vérification d'effacement, ni la temporisation de durée T2, ce qui contribue de manière significative à la diminution de la durée totale du processus d'effacement.

L'élimination du cycle d'écriture et de la temporisation présents antérieurement dans la boucle de vérification est rendue possible par un agencement de la logique de contrôle des mémoires programmables concernées par le procédé selon l'invention, comme l'illustre le schéma de la figure 2.

La mémoire programmable de type EPROM 10 comprend, à titre d'exemple et conformément à l'état actuel de la technique, un plan mémoire PM, un bus de données interne 11 bidirectionnel relié via un bus de données externe BD au système numérique extérieur, un bus d'adresse interne 12 monodirectionnel relié à travers un registre d'adresse RA à un bus d'adresse externe BA commandé par le système extérieur. Elle reçoit également des signaux usuels de validation CE, OE conformément à l'état présent de la technique. Ces signaux sont traités par une logique de contrôle 21 dont la structure et le fonctionnement sont bien connus de l'homme de métier et ne seront pas donc explicités ici, et qui contrôle également l'utilisation de la tension de programmation Vpp.

Le registre de commande RC est relié au bus de données interne 11 via un décodeur de statut R et délivre des signaux usuels nécessaires pour la commande interne de la mémoire, notamment en lecture, en effacement ou en programmation, mais aussi un signal de vérification d'effacement rapide FEV spécifique de l'invention.Le registre de commande RC est commandé par un signal d'horloge de donnée DCLK lui même généré par un détecteur de fronts 13 recevant en entrée un signal d'autorisation d'écriture WE, et délivrant également une impulsion ACLK déclenchée par chaque front descendant du signal WE.

Le registre d'adresse RA est commandé par un signal ALE (autorisation de transfert d'adresse) résultat d'une opération NON ET logique effectuée par une porte logique 15 entre le signal FEV préalablement inversé par une porte inverseuse 14 et le signal ACLK préalablement inversé par une porte inverseuse 22. Le transfert de l'adresse effectivement présente sur le bus d'adresse externe BA est autorisé sur le bus d'adresse interne 12 dès lors que l'un ou l'autre des signaux ACLK et FEV est au niveau logique haut.

La combinaison du décodeur R, du détecteur 13, des portes logiques 14, 15 et 22, et du registre d'adresse RA constitue le dispositif 20 de vérification d'effacement selon l'invention, qui est normalement intégré au sein du circuit mémoire selon les techniques connues de l'homme de métier.

On va maintenant décrire, en référence au chronogramme de la figure 3, les différents transferts d'information effectués au cours de l'exécution de l'algorithme d'effacement incluant le procédé de vérification d'effacement selon l'invention.

Au début de la séquence d'effacement E, le système numérique extérieur applique une tension de programmation Vpp (par exemple 12 volts) et génère une impulsion basse sur l'entrée d'autorisation d'écriture WE, qui au repos est au niveau logique haut, puis délivre sur le bus de données BD un mot de commande de préparation à l'effacement PE qui est pris en compte par la registre de commande après décodage du signal WE. Ensuite, le système extérieur génère de nouveau une impulsion basse sur l'entrée d'autorisation d'écriture WE, puis envoie via le bus de données BD un mot de commande d'effacement CE. A l'issue de cet envoi, une temporisation TE est effectuée afin de garantir un effacement correct de l'ensemble du plan mémoire. Ensuite, Le système extérieur génère de nouveau une impulsion basse sur l'entrée d'autorisation d'écriture WE, puis un mot de commande de vérification d'effacement CV via le bus de données. Ce mot de commande de vérification d'effacement CV est décodé à l'issue d'une impulsion WE et conduit à La génération du signal FEV (Cf figure 2). La temporisation de durée T2, par exemple 6 µs, est enclenchée de façon à garantir la stabilisation des circuiteries statiques de lecture en mode de vérification d'effacement. La mise au niveau logique haut de FEV provoque la passage du signal ALE au niveau haut et donc l'ouverture du registre RA qui devient ainsi transparent. Le système extérieur peut alors générer des cycles de lecture en appliquant sur le bus d'adresses BA les adresses A0, A1, A2,... AN successives et en recevant en retour, sur le bus de données BD, les données respectives D0, D1, D2,... DN pour vérification. Les comparaisons des données lues avec des données de référence (contenu numérique normal attendu après effacement) sont naturellement effectuées dans le système numérique extérieur (non représenté) comme il a été indiqué. On remarque aisément qu'avec le procédé selon l'invention, la scrutation du plan mémoire n'est plus entravée par une écriture systématique d'un mot de commande de vérification d'effacement qui contribuait à ralentir significativement le processus d'effacement.

Le procédé de vérification selon l'invention est particulièrement approprié aux mémoires FLASH EPROM pour lesquelles il a été initialement prévu.

Bien entendu, l'invention n'est pas limitée aux exemples qui viennent d'être décrits et de nombreux autres aménagements de l'invention peuvent être envisagés sans sortir du cadre de la présente invention.

Ainsi, l'application du procédé selon l'invention n'est pas limitée à un type particulier de mémoire EPROM, mais peut être envisagée pour tout type de mémoire programmable et effaçable.

Par ailleurs, l'ouverture du registre d'adresse peut être réalisée par d'autres agencements logiques que celui décrit ci-dessus uniquement à titre d'exemple, en fonction des ressources logiques effectivement disponibles dans la topographie du circuit mémoire.

## Revendications

1. Procédé (V) pour vérifier le contenu après effacement d'une mémoire permanente effaçable (10), notamment de type EPROM comprenant un registre de commande (RC) et un registre d'adresse (RA), le procédé comprenant une première étape (V1) d'écriture dans ledit registre de commande (RC) d'un mot de commande de vérification d'effacement (CV), suivie d'une seconde étape (TV) de temporisation de durée prédéterminée (T2),
caractérisé en ce que la première étape (V1) d'écriture du mot de commande initie la séquence suivante :
- ouverture du registre d'adresse (RA),
- présentation d'une première adresse (A0),
- bouclage itératif (B) de lecture et de test du contenu à l'adresse visée et incrémentation de cette adresse jusqu'à ce que l'ensemble de la mémoire (10) ait été vérifié, et
- fermeture du registre d'adresse (RA).

2. Procédé (V) selon la revendication 1, caractérisé en ce que le bouclage (B) comprend une étape (VL) de lecture de la donnée mémoire (D) contenue à l'adresse en cours, suivie d'une étape (V2) de comparaison de ladite donnée (D) avec une donnée de référence (FFH) d'effacement, ladite étape de comparaison conduisant soit à une nouvelle itération en cas d'identité, soit à l'exécution d'une nouvelle séquence d'effacement (E) en cas de différence.

3. Procédé selon la revendication 2, caractérisé en ce que le bouclage (B) comprend en outre une étape de test d'adresse (V3) pour détecter une fin de scrutation de la mémoire (10), conduisant soit à une nouvelle étape de lecture (VL), soit à une séquence de fin d'effacement (F).

4. Mémoire permanente effaçable (10), notamment de type EPROM, mettant en oeuvre le procédé selon l'une des revendications précédentes, caractérisée en ce que ladite mémoire comporte un registre d'adresse (RA), un registre de commande (RC) relié à un bus de données interne (11) via un décodeur de statut (R), et un détecteur de fronts (13) recevant en entrée un signal d'autorisation d'écriture (WE), et en ce qu'elle comprend en outre des moyens pour générer un signal d'autorisation de transfert d'adresse (ALE) appliqué sur le registre d'adresse (RA) à partir d'un signal de vérification d'effacement rapide (FEV) généré par le registre de commande (RC) et d'un signal d'horloge d'adresse (ACLK) généré par le détecteur de fronts (13).

5. Mémoire selon la revendication 4, caractérisé en ce que les moyens pour générer un signal d'autorisation comprennent une porte logique NON ET (15) à deux entrées recevant en entrées l'inverse logique du signal d'horloge d'adresse (ACLK) issu d'une porte inverseuse (22) et l'inverse logique du signal de vérification d'effacement rapide (FEV) issu d'une porte logique inverseuse (14), et délivrant en sortie le signal d'autorisation de transfert d'adresse (ALE).

## Patentansprüche

1. Verfahren (V) zum Überprüfen des Inhalts nach dem Löschen eines Löschbaren, nichtflüchtigen Speichers (10), insbesondere vom Typ EPROM, der ein Befehlsregister (RC) und ein Adressenregister (RA) aufweist, wobei das Verfahren einen ersten Schritt (V1) aufweist, in dem ein Befehlswort für die Überprüfung des Löschen (CV) in das Befehlsregister (RC) geschrieben wird, gefolgt von einem zweiten Verweilschritt (TV) von bestimmter Dauer (T2),
dadurch gekennzeichnet, daß der erste Schritt (V1) für das Schreiben des Befehlswortes folgenden Ablauf nach sich zieht:
- Öffnung des Adressenregisters (RA),
- Darbietung einer ersten Adresse (A0),
- iterative Schleife (B) zum Lesen und Testen des Inhalts an der Zieladresse und Inkrementierung dieser Adresse bis die Gesamtheit des Speichers (10) überprüft worden ist, und
- Schließen des Adressenregisters (RA).

2. Verfahren (V) nach Anspruch 1, dadurch gekennzeichnet, daß die Schleife (B) einen Schritt (VL) zum Lesen der Speicherdaten (D), die die aktuelle Adresse beinhaltet, gefolgt von einem Schritt (V2) für den Vergleich dieser Daten (D) mit einer Referenzgröße (FFH) für das Löschen aufweist, wobei der Vergleichsschritt entweder im Falle von Gleichheit zu einer neuen Iteration führt, oder im Falle von Unterschiedlichkeit zur Ausführung einer neuen Löschungsabfolge (E) führt.

3. Verfahren nach Anspruch 2, dadurch gekennzeichnet, daß die Schleife (B) darüber hinaus einen Schritt (V3) für das Testen von Adressen aufweist, um ein Ende der Speicherabfrage des Speichers (10) zu detektieren, was entweder zu einem neuen Leseschritt (VL) führt, oder zu einer neuen Abfolge für das ende des Löschen (F).

4. Löschbarer, nichtflüchtiger Speicher (10), insbesondere vom Typ EPROM, mit dem das Verfahren nach einem der vorhergehenden Ansprüche umgesetzt wird, dadurch gekennzeichnet, daß der Speicher ein Adressenregister (RA) aufweist, ein Befehlsregister (RC), das über einen internen Datenbus über einen Statusdekoder (R) angeschlossen ist, und einen Flankendetektor (13), der am Eingang ein Signal für die Freigabe zum Schreiben (WE) empfängt, und dadurch gekennzeichnet, daß er darüber hinaus eine Einrichtung aufweist zum Erzeugen eines Signals für die Freigabe der Adressenübertragungen (ALF), das auf ein Signal hin für die Überprüfung des schnellen Löschens (FEV), das von dem Befehlsregister (RC) erzeugt wird, und ein Taktsignal hin für die Adresse (ACLK), das von dem Flankendetektor (13) erzeugt wird, an das Adressenregister (RA) angelegt wird.

5. Speicher nach Anspruch 4, dadurch gekennzeichnet, daß die Einrichtung für die Erzeugung eines Signals für die Freigabe einen logischen Anschluß NICHT UND (15) mit zwei Eingängen aufweist, die am Eingang die logische Invertierung des Taktsignals für die Adresse (ACLK) empfangen, das von einem Invertiergatter (22) kommt, und die logische Invertierung des Signals für die Überprüfung des schnellen Löschens (FEV) empfängt, das von einem logischen Invertierausgang (14) kommt, und am Ausgang ein Signal für die Freigabe der Adressenübertragung (ALE) liefert.

## Claims

1. Method (V) for checking the content after erasure of an erasable permanent memory (10), notably of the EPROM type, comprising a control register (RC) and an address register (RA), the method comprising a first step (V1) of writing a word (CV) controlling the erasure check in the said control register (RC), following by a second time delay step (TV) of predetermined duration (T2),
characterised in that the first step (V1) of writing the control word initiates the following sequence:
- opening of the address register (RA),
- presentation of a first address (A0),
- iterative looping (B) for reading and testing the content at the relevant address and incrementation of this address until the entire memory (10) has been checked, and
- closure of the address register (RA).

2. Method (V) according to Claim 1, characterised in that the looping (B) comprises a step (VL) of reading the memory data item (D) contained at the current address, followed by a step (V2) of comparing the said data item (D) with an erasure reference data item (FFH), the said comparison step leading either to a new iteration if identical, or to the execution of a new erasure sequence (E) if different.

3. Method according to Claim 2, characterised in that the looping (B) also comprises an address testing step (V3) for detecting an end of scanning of the memory (10), leading either to a new reading step (VL) or to an end-of-erasure sequence (F).

4. Erasable permanent memory (10), notably of the EPROM type, implementing the method according to one of the preceding claims, characterised in that the said memory has an address register (RA) a control register (RC) connected to an internal data bus (11) via status decoder (R), and an edge detector (13) receiving at its input a write enable signal (WE), and in that it also comprises means for generating an address transfer enable signal (ALE) applied to the address register (RA) from the rapid erasure check signal (FEV) generated by the control register (RC) and an address clock signal (ACLK) generated by the edge detector (13).

5. Memory according to Claim 4, characterised in that the means for generating an enable signal comprise a logic NOR gate (15) with two inputs receiving as inputs the logic inverse of the address clock signal (ACLK) coming from an inverter gate (22) and the logic inverse of the rapid erasure check signal (FEV) coming from an inverter logic gate (14) and delivering at its output the address transfer enable signal (ALE).
